Europäisches Patentamt

European Patent Office

Office européen des brevets

(11) Publication number: **0 490 469 A1**

# EUROPEAN PATENT APPLICATION

(21) Application number: **91308488.5**

(22) Date of filing: **18.09.91**

(51) Int. Cl.⁵: **C23C 14/04**, C23C 14/56, C23C 14/34, B01D 39/12

(30) Priority: **07.12.90 US 623686**

(43) Date of publication of application:
**17.06.92 Bulletin 92/25**

(84) Designated Contracting States:
**DE FR GB**

(71) Applicant: **BRUNSWICK CORPORATION**
**One Brunswick Plaza**
**Skokie Illinois 60077(US)**

(72) Inventor: **Parsons, Delbert W.**
**959 Tiller Way**

Corona Del Mar, California 92625(US)
Inventor: **Jackson, Michael M.**
**427 Heliotrope**
**Corona Del Mar, California 92625(US)**
Inventor: **Nehls, Bruce D.**
**1515 Bonnie Doone Terrace**
**Corona Del Mar, California 92625(US)**

(74) Representative: **Allden, Thomas Stanley et al**
**A.A. THORNTON & CO. Northumberland**
**House 303-306 High Holborn**
**London WC1V 7LE(GB)**

(54) Method of reducing pore size of fine wire mesh screen.

(57) A method of uniformly reducing the size of pores in a fine wire mesh screen is provided to reduce the size of particulates passible through the screen. The screen (16) is placed in a vacuum chamber (10) with a target material (32). Atoms are transferred from the target material to the screen in a random fashion by bombarding the target material with ions such that the surface ejected atoms from the target material randomly collect on the screen and form a thin film coating thereon to reduce the size of the pores in the screen. The target material is electrically charged with a negative voltage to accelerate positively charged ions into bombardment therewith.

## Fig. 1

## Field of the Invention

This invention generally relates to the art of producing fine wire mesh screen, such as for use as a filtration media, and particularly to a method of reducing the size of the pores in the screen to thereby reduce the size of particulates passible through the filtration media.

## Background of the Invention

Fine wire mesh screens are used in a wide variety of applications ranging from use as a filtration media to use as a propellant management device in rocket motor art. One of the problems in producing such screens involves the manufacturing limitations on the mesh size ranges due to the physical properties of the metal or alloy material of the wire used in weaving the wire cloth which makes up the screen. The result is that the pore size (e.g., a filtration media) is limited and, therefore, reducing the size of particulates passible through the filtration media reaches a finite limit simply based on the physical properties of the wires and the manufacturing or weaving process.

Heretofore, various attempts have been made to reduce the pore size of fine wire mesh screen by various metal deposition processes as post-manufacture procedures, i.e., after the basic screen has been made or woven. A disadvantage of many such processes is that they result in considerable thickening of the screen in comparison to minute closing of the pores in the screen. In many applications, it is not desirable or acceptable to significantly alter the bulk properties of the screen or add appreciable weight thereto.

An example of coating a fine screen of metal fabric with a metal coating is shown in U.S. Patent No. 4,655,797 to Iniotakis, dated April 7, 1987. In that patent, a galvanic process is used; i.e., two electrodes are employed in conjunction with an electrolyte. A potential differential between the two electrodes causes ions to break free and travel to a targeted surface of high electric potential. Theoretically, the porosity of the screen is reduced, thereby increasing its retention capability. However, unfortunately, in such galvanic and/or chemical metal deposition processes, the ions in solution travel the shortest paths and the linear travel tends to significantly thicken the screen in comparison to reducing its porosity. Such processes are undesirable or unacceptable in applications where the bulk properties of the screen must not be significantly altered or the weight of the screen must not be appreciably increased.

U.S. Patent No. 2,940,873 to Toohig, dated June 14, 1960, shows a method of depositing metal on a fine mesh metal screen by evaporating metal onto the screen in a high vacuum. The metal molecules emanate from a point source where the evaporated metal is boiled to cause a vapor pressure to build up, and the metal molecules travel in straight lines to the screen. The molecules which impinge on the screen accumulate to increase the thickness of the screen, and the remaining molecules pass directly through the screen and condense on a surface beyond. In fact, the method of Toohig is specifically designed to increase the thickness of the fine mesh metal screen without appreciably reducing its porosity. Again, such a process would be totally inapplicable for purposes of reducing the porosity of fine wire mesh screens without altering bulk properties or adding appreciable weight.

This invention is directed to solving the above problems by providing a method of reducing the size of the pores in a fine wire mesh screen without significantly altering the bulk properties of the screen or adding appreciable weight to the screen.

## Summary of the Invention

An object, therefore, of the invention is to provide a new and improved method of uniformly reducing the size of pores in a fine mesh screen, such as a filtration media, to thereby reduce the size of particulates passible through the screen.

Generally, the invention contemplates a method of transferring atoms to a fine wire mesh screen in a random fashion to form a thin film coating thereon and reducing the size of the pores therein.

More particularly, the fine wire mesh screen and a target material are placed in a vacuum chamber. Atoms are transferred from the target material to the screen in a random fashion by bombarding the target material with ions such that surface ejected atoms from the target material randomly collect on the screen and form a thin film coating thereon and reducing the size of the pores therein. As used herein and in the claims hereof, the term "random" is meant to mean movement of the atoms in omnidirectional paths versus the unidirectional paths of the prior art described above.

The method of the invention has been proven effective with metals such as titanium, stainless steel and aluminum.

Still more specifically, the target material in the vacuum chamber is electrically charged with a negative voltage. Positive ions are supplied to the chamber and the negative charge on the target material accelerates the positive ions into bombardment with the target material to free atoms therefrom for collection on the screen. For instance, the screen may be of a titanium alloy material and the target material may be unalloyed titanium.

In the exemplary embodiment of the invention, the fine wire mesh screen is placed in the vacuum chamber by a continuous web moving past the target material. This further enhances the random deposition of the atoms onto the screen. Still further, the vacuum chamber may be divided into regions through which the fine wire mesh screen is moved seriatim, and at least one unit of target material is placed in each region along the path of movement of the fine wire mesh screen.

Preferably, the wire mesh screen is fabricated by using a "Dutch twilled" weave in comparison to a square weave. In other words, the mesh count of the wire screen or cloth has more shute wires than warp wires, the shute wires running transverse of the moving web and the warp wires running the length of the web. This also has proven effective in reducing the porosity of the screen without altering bulk properties or adding appreciable weight.

Other objects, features and advantages of the invention will be apparent from the following detailed description taken in connection with the accompanying drawings.

Brief Description of the Drawings

The features of this invention which are believed to be novel are set forth with particularity in the appended claims. The invention, together with its objects and the following description taken in conjunction with the accompanying drawings, in which like reference numerals identify like elements in the figures and in which:

FIGURE 1 is a schematic illustration of a vacuum chamber and associated apparatus for carrying out the method of the invention; and

FIGURE 2 is a schematic illustration of the ionic bombardment and atom transfer of the method contemplated by the invention.

Detailed Description of the Preferred Embodiment

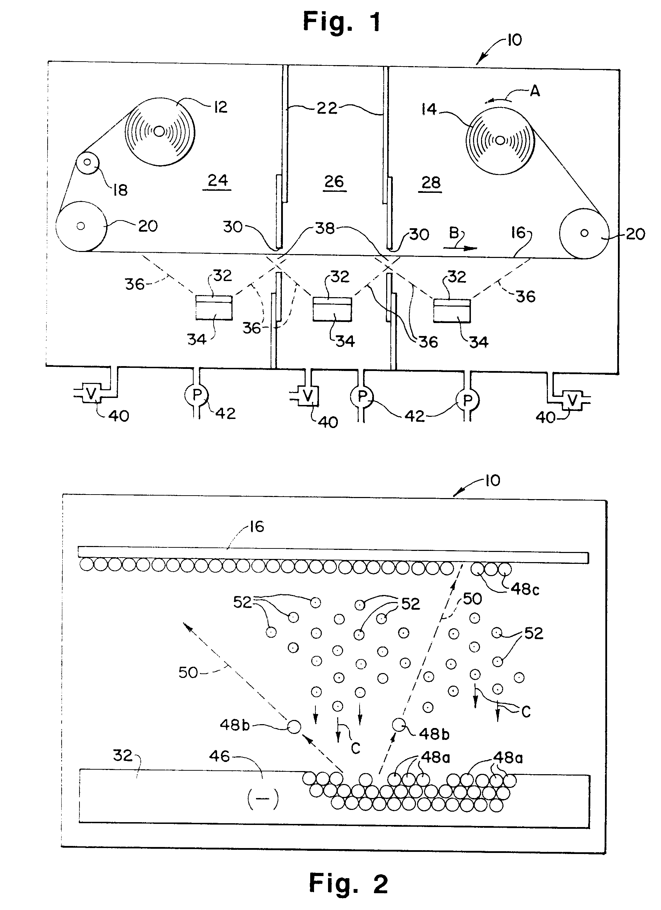

Referring to the drawings in greater detail, the invention is illustrated in Figure 1 in association with the schematics of a vacuum chamber, generally designated 10, within which the method of the invention takes place. Generally, the method contemplates placing a fine wire mesh screen and a target material in chamber 10 and transferring atoms from the target material to the screen in a random fashion by bombarding the target material with ions such that surface ejected atoms from the target material randomly collect on the screen. This forms a thin film coating on the screen, reducing the size of the pores in the screen, and without significantly altering the bulk properties of the screen or adding any appreciable weight to the screen.

Before proceeding with a detailed description of Figure 1, it should be noted that the depiction shows the fine wire mesh screen moving in a continuous web for mass production purposes. Obviously, finite sizes of screens can be placed in a vacuum chamber and the method of the invention carried out as described above for a finite period of time.

Specifically, Figure 1 shows a supply roll 12 and a take up roll 14, both of which may be driven, but at least take up roll 14 is driven in the direction of arrow "A" to move a web of fine wire mesh screen 16 around an idler roll 18 and a pair of spaced positioning rolls 20. The positioning rolls define a path of movement for the screen, as indicated by arrow "B".

Chamber 10 has partitions 22 for dividing the chamber into three regions 24, 26 and 28. Therefore, it can be seen that web or screen 16 moves through openings 30 in the partitions seriatim from supply roll 12 through region 24, then through intermediate region 26 and into region 28 and is taken up onto roll 14.

A unit of target material 32 is disposed in each region 24-28, each unit of target material being electrically charged with a negative voltage by a cathode 34. As will be described in greater detail with respect to Figure 2, atoms are transferred from target material 32 to screen 16 in a random fashion by bombarding the target material with positive ions such that surface ejected atoms from the target material randomly collect on the screen to form a thin film coating thereon and reduce the size of the pores in the screen. Dotted lines 36 emanating from each unit of target material 32 represent a zone from which atoms are ejected toward screen 16. For uniformity purposes, apertures 30 in partitions 22 are somewhat enlarged on the lower side of the screen so that there are provided overlapping areas 38 in which the ejection zones of the units of target material in the distinct regions 24-28 overlap.

Figure 1 also shows that a vacuum 40 is applied individually to regions 24-28. In addition, cryo-pumps 42 communicate with each region for supplying positive ions into vacuum chamber 10 by supplying the ions to the regions individually. The ions can be supplied of argon or the like.

Of course, vacuum chamber 10 would have a cover or be fabricated of multiple assembled components to gain access to the interior thereof for loading and unloading the screen or for replacing the target material or for other maintenance and processing purposes.

Figure 2 conceptually illustrates what occurs primarily in the zones defined by dotted lines 36 in Figure 1, between target material 32 and screen 16, whereby atoms are transferred from the target material to the screen. More particularly, target material 32 is shown, as at 46, to be electrically charged with a negative voltage. This can be accomplished by any known means, such as cathodes 34 (Fig. 1). Circles 48a represent surface atoms on target material 32. The two circles 48b represent atoms being ejected from the surface of the target material toward screen 16, as indicated by dashed arrows 50. Circles 48c represent atoms that have been collected on screen 16 to form a thin film coating thereon. At this point, it should be understood that Figure 2 simply conceptualizes the process, and screen 16 has pores therein, the sides of which are coated with the thin film.

Positive ions 52 are supplied to chamber 10 (i.e., pumps 42 for each chamber region 24-28) whereby, in essence, a cloud of positive ions float between negatively charged target material 32 and screen 16. These positive ions are accelerated toward target material 32, as indicated by arrows "C". Upon bombardment of the positive ions with the negatively charged material, surface atoms 48a are ejected and travel in a myriad of directions, as at 48b, until they collect onto screen 16, as at 48c. If the target material and the screen are chemically compatible, a very fine coating will form on the screen, in a random fashion to thereby reduce the pores in the screen. For instance, a titanium alloy screen could be coated by using a titanium target material. The coating is quite uniform due to the random ejection of the atoms from the target material in an omni-directional manner within the zones above the exposed or bombarded surface of the target material, such as the zones schematically illustrated by dotted lines 36 in Figure 1. With this atom ejection system, the sides of the wires in the pores of the screens are coated substantially equally with the sides of the wires facing directly toward the target material. The thickness of the overall coating will be governed primarily by the speed of transporting the screen web 16 through the ion bombardment/atom ejection zones between the target material and the screen.

In proven testing, a vacuum tank on the order of 700 cubic feet has been proposed. The rolls of screen webbing can be from 10,000-20,000 feet in linearly running length. The speed of movement of the screen web can be up to 100 feet per minute, again the speed determining the thickness of the deposited film. The screen web can be as wide as 62 inches, and cathodes/target material assemblies can be on the order of 74 x 12 inches n size. A vacuum has been applied on the order of $10^4$ mmHg. Cryo-pumps 42 can operate at 30,000 liters/sec. $H_2O$. A Dutch twill weave for fine mesh screen 16 having a mesh count of approximately 165 warp wires per 800 shute wires has proven effective. A weave having a mesh count of 325 warp wires per 2300 shute wires has also been proven effective. In a titanium application, target material 32 of an unalloyed titanium has been used per ASTM-B-348 grade 1. The wire fabric may be an industrial type per RR-W-360 type 2 Class 2.

From the foregoing, it can be seen that a new and improved method of uniformly reducing the size of pores in a fine wire mesh screen is possible to reduce the size of particulates passible through the screen without significantly increasing the thickness or bulk properties of the screen in comparison to the reduction in the pores through the screen. The ionic bombardment/atom ejection process directs atoms for deposition or collection on the screen in a random or nonlinear direction without the limitations of uni-directional or linear deposition of prior systems.

It will be understood that the invention may be embodied in other specific forms without departing from the spirit or central characteristics thereof. The present examples and embodiments, therefore, are to be considered in all respects as illustrative and not restrictive, and the invention is not to be limited to the details given herein.

## Claims

1. A method of uniformly reducing the size of pores in a fine wire mesh screen to thereby reduce the size of particulates passable through the screen, comprising the steps of:
   placing said fine wire mesh screen and a target material in a chamber; and
   transferring atoms from the target material to the screen in a random fashion by bombarding the target material with ions such that surface ejected atoms from the target material randomly collect on the screen and form a thin film coating thereon reducing the size of the pores therein.

2. A method as claimed in claim 1, including maintaining said chamber at a vacuum.

3. A method of uniformly reducing the size of pores in a fine wire mesh screen to thereby reduce the size of particulates passable through the screen, comprising the steps of:
   placing said fine wire mesh screen and a target material in a vacuum chamber, the target material being electrically charged with a negative voltage; and
   transferring atoms from the target material to the screen in a random fashion by bombarding the target material with positively charged ions such that surface ejected atoms from the target material randomly collect on the screen and form a thin film coating thereon reducing the size of the pores therein.

4. A method of uniformly reducing the size of pores in a fine wire mesh screen to thereby reduce the size of particulates passable through the screen, comprising the steps of:

placing a continuous web of said fine wire mesh screen and a target material in a vacuum chamber;

electrically charging the target material with a negative voltage;

supplying said chamber with a supply of positive ions; and

moving the continuous web of fine wire mesh screen past the target material whereby atoms from the target material are transferred to the screen in a random fashion by bombarding the negatively charged target material with the positive ions such that surface ejected atoms from the target material randomly collect on the screen and form a thin film coating thereon reducing the size of the pores therein.

5. A method as claimed in any of claims 1 to 3, wherein said target material is electrically charged with a negative voltage to accelerate positively charged ions into bombardment therewith.

6. A method as claimed in any of claims 1, 2, 3 or 5, including supplying said chamber with a supply of said ions.

7. A method as claimed in any of claims 1, 2, 3, 5 or 6, wherein said fine wire mesh screen is placed in the chamber by a continuous web moving past the target material.

8. A method as claimed in claim 4 or claim 7, including placing a plurality of units of said target material in the chamber along the path of movement of the fine wire mesh screen.

9. A method as claimed in claim 8, wherein said chamber is divided into regions, said fine wire mesh screen is moved seriatim through the regions, and including placing at least one unit of target material in each region.

10. A method as claimed in any of claims 4, 7, 8 or 9, wherein said screen is woven with shute wires running transverse of the moving web and warp wires running lengthwise of the web, there being more shute wires than warp wires per unit area.

11. A method as claimed in claim 10, wherein said screen is provided with approximately 165 warp wires per 800 shute wires.

12. A method as claimed in any of the preceding claims, wherein said screen and said target material are provided of titanium, stainless steel or aluminium.

13. A method of uniformly reducing the size of pores in a fine wire mesh screen to thereby reduce the size of particulates passable therethrough, comprising exposing the fine wire mesh screen to a target material and transferring atoms from the target material to the screen in a random fashion to form a thin film coating on the screen reducing the size of the pores in the screen.

14. A method as claimed in claim 13, wherein said target material is bombarded by ions such that surface ejected atoms from the target material are emitted toward the screen.

EP 0 490 469 A1

**Fig. 1**

**Fig. 2**

6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | DE-A-3 515 025 (ALTENBURGER ELECTRONIC) <br> * column 2, line 37 - line 58; claims 1,5-7 * <br> --- | 1,13 | C23C14/04 <br> C23C14/56 <br> C23C14/34 <br> B01D39/12 |
| A | EP-A-0 151 064 (SORAPEC) <br> * claims 1,2,9,10 * <br> --- | 1,13 | |
| A | EP-A-0 099 174 (FAZLIN) <br> * page 15, paragraph 2; claim 1 * <br> --- | 1-3,5,6 | |
| A | EP-A-0 392 082 (KATAYAMA SPECIAL INDUSTRIES) <br> * column 16, line 47 - column 17, line 55; figure 12 * <br> * column 18, line 57 - column 19, line 4 * <br><br> ----- | 1,4,7 | |
| | | | TECHNICAL FIELDS SEARCHED (Int. Cl.5) |
| | | | C23C <br> B01D |

The present search report has been drawn up for all claims

| Place of search | Date of completion of the search | Examiner |
|---|---|---|
| THE HAGUE | 12 MARCH 1992 | PATTERSON A.M. |

EPO FORM 1503 03.82 (P0401)